# DEMANDE DE BREVET EUROPEEN

(11) **EP 1 895 596 A1**
(43) Date de publication de la demande: **05.03.2008**
(21) Numéro de dépôt: 07354046.0
(22) Date de dépôt: 24.08.2007
(51) Int. Cl.: H01L 29/786, H01L 21/8242, H01L 29/78, H01L 27/108

(54) **Cellule mémoire DRAM sans capacité constituée d'un dispositif de type MOSFET partiellement déserté comportant un isolant de grille en deux parties**

(30) Priorité: 01.09.2006 FR 0607691; 15.05.2007 FR 0703486
(71) Demandeur: Commissariat à l'Energie Atomique, 75015 Paris (FR)
(72) Inventeur: Guegan, Georges, 38180 Seyssins (FR)
(74) Mandataire: Jouvray, Marie-Andrée

(57) **Abrégé**

La cellule mémoire DRAM sans capacité est constituée d'un dispositif de type MOSFET partiellement déserté qui comporte successivement un substrat de base (6), un isolant enterré (7), un substrat flottant en matériau semi-conducteur incluant un canal (2), l'isolant de grille (8) et une grille (3). La grille (3) comporte une première zone (3a) dopée par un premier type de dopant et une seconde zone (3b) dopée par un second type de dopant. Le canal (2) est dopé par le second type de dopant. L'isolant de grille (8) comporte une première partie (8a) correspondant à la première zone dopée (3a) et une seconde partie (8b) correspondant à la seconde zone dopée (3b) de la grille (3). La première partie (8a) de l'isolant de grille (8) a une résistance tunnel plus élevée que la seconde partie (8b) de l'isolant de grille (8).

## Description

### Domaine technique de l'invention

L'invention est relative à une cellule mémoire DRAM sans capacité constituée par un dispositif de type MOSFET partiellement déserté comportant successivement un substrat de base, un isolant enterré, un substrat flottant en matériau semi-conducteur incluant un canal, au moins un isolant de grille et une grille, la grille comportant une première zone dopée par un premier type de dopant et au moins une seconde zone dopée par un second type de dopant, le canal en matériau semi-conducteur étant dopé par le second type de dopant.

### État de la technique

Les technologies de type SOI (« silicon on insulator ») présentent de nombreux avantages, par exemple :
- une bonne tenue aux irradiations,
- une bonne isolation diélectrique des transistors et des circuits et, ainsi, une absence des effets de type latch-up, c'est-à-dire de flux de courants entre les transistors PMOS et NMOS d'un circuit CMOS,
- une réduction des effets de canal court,
- une réduction des capacités parasites des jonctions, conduisant à un fonctionnement des circuit plus rapide et à une réduction des puissances consommées.

Les dispositifs de type SOI peuvent être divisés en deux grandes familles : les dispositifs complètement désertés, et les dispositifs partiellement désertés. Dans les dispositifs partiellement désertés contrôlés par une grille, la zone de charge d'espace n'atteint pas l'isolant enterré.

Cependant, de manière générale, les dispositifs partiellement désertés sont limités par les effets de substrat flottant, notamment pour des applications analogiques.

Par ailleurs on cherche à améliorer les performances des dispositifs en termes de courants délivrés, de gain de mobilité et de réduction de la consommation des circuits. Les effets de substrat flottant entraînent une augmentation du courant de saturation (effet de type « kink ») qui est très pénalisante pour les applications analogiques.

Le document US2005/0072975 décrit un dispositif de type MOSFET, partiellement déserté, formé à partir d'un substrat de type SOI (« silicon on insulator »), comportant successivement un substrat de base, un isolant enterré, un canal en matériau semi-conducteur, un isolant de grille et une grille. La grille comporte une première zone dopée par un premier type de dopant et au moins une seconde zone dopée par un second type de dopant. Le canal en matériau semi-conducteur est dopé par le second type de dopant. Les source et drain sont dopés par le premier type de dopant.

Une connexion par effet tunnel est, ainsi, formée entre la seconde zone dopée et le canal du transistor, si l'épaisseur de l'isolant de grille est faible, par exemple comprise entre 1 nm et 2,2nm. Ceci permet de modifier la charge et le potentiel de la couche semi-conductrice dans laquelle est formé le canal et, ainsi, de réduire la valeur absolue de la tension de seuil du dispositif MOSFET. Cette réduction de la tension de seuil entraîne une augmentation du courant délivré. De plus, la pente en faible inversion, qui traduit le pouvoir de coupure d'un transistor de l'état bloqué à l'état passant, est améliorée en raison d'une variation plus faible de la capacité de déplétion avec la polarisation appliquée sur la grille. La réduction de la valeur absolue de la tension de seuil entraîne une réduction du champ électrique en régime de saturation au voisinage du drain et une diminution de l'ionisation par impact.

Par ailleurs, la mise en oeuvre d'un courant tunnel entre la grille et le canal permet d'obtenir une augmentation de la conductivité à l'état passant, une réduction de l'ionisation par impact et de l'effet de type kink, un gain de mobilité et une réduction des effets de canal court.

Par contre, ces avantages sont réduits dans le cas d'utilisation de tensions élevées, notamment pour des applications analogiques.

Le document US2005/0072975 décrit un dispositif de type MOSFFET partiellement déserté formé sur un substrat sur isolant (SOI) comprenant successivement un substrat de base, un isolant enterré, un substrat flottant en matériau semi-conducteur incluant un canal, au moins un isolant de grille et une grille. La grille comporte une première zone dopée par un premier type de dopant et au moins une seconde zone dopée par un second type de dopant. Le canal en matériau semi-conducteur est dopé par le second type de dopant. Les zones de source et de drain sont dopées par le premier type de dopant.

Les dispositifs de type MOSFFET partiellement déserté peuvent être utilisés en tant que cellule mémoire de type DRAM sans capacité. Pour ce type de mémoire, le stockage d'information est réalisé au sein du dispositif au moyen de l'effet de substrat flottant couramment rencontré dans les dispositifs de type MOSFFET partiellement déserté.

De manière classique, cette catégorie cellule mémoire sans capacité est obtenue par l'intermédiaire de transistors de type NMOS. Pour ce genre de cellule mémoire, les porteurs de charge (des trous dans le cas de transistors NMOS) sont injectés dans la zone neutre du substrat flottant. Ces porteurs de charges, confinés dans une région bordée par de l'oxyde enterré, l'oxyde de grille et les jonctions de source et de drain, s'accumulent dans le substrat flottant et modifient son potentiel. Dans le cas d'un NMOS, cette augmentation de potentiel est directement reliée à la jonction entre la source et le substrat flottant. Ainsi, la tension de seuil du transistor est réduite et le courant de drain augmenté. Dans ce cas, le substrat flottant est utilisé en tant que zone de rétention d'une charge mémoire. Cette charge mémorisée (état 1 de la mémoire) peut être évacué en polarisant en direct la jonction drain/substrat. L'état 0 de la mémoire correspond à une absence de charge dans le substrat flottant.

Dans ces cellules mémoires, la création de charge est réalisée par l'ionisation par impact, qui permet l'accumulation d'une grande quantité d'électrons. D'une manière générale, les porteurs de charges sont injectés dans ces cellules mémoires au moyen d'un champs électrique élevé qui est préjudiciable à la fiabilité des dispositifs.

### Objet de l'invention

Le but de l'invention consiste à réaliser une cellule mémoire DRAM sans capacité dont le fonctionnement ne dégrade pas la fiabilité du dispositif de type MOSFET partiellement déserté.

Selon l'invention, ce but est atteint par la cellule mémoire DRAM sans capacité selon les revendications annexées.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- les figures 1 à 4 représentent, respectivement en vue de dessus et en coupe selon les axes A-A, B-B et C-C, un mode de réalisation particulier d'une cellule mémoire selon l'invention.,
- la figure 5 représente, en coupe selon l'axe A-A, un autre mode de réalisation particulier d'une cellule mémoire selon l'invention.

### Description d'un mode préférentiel de l'invention

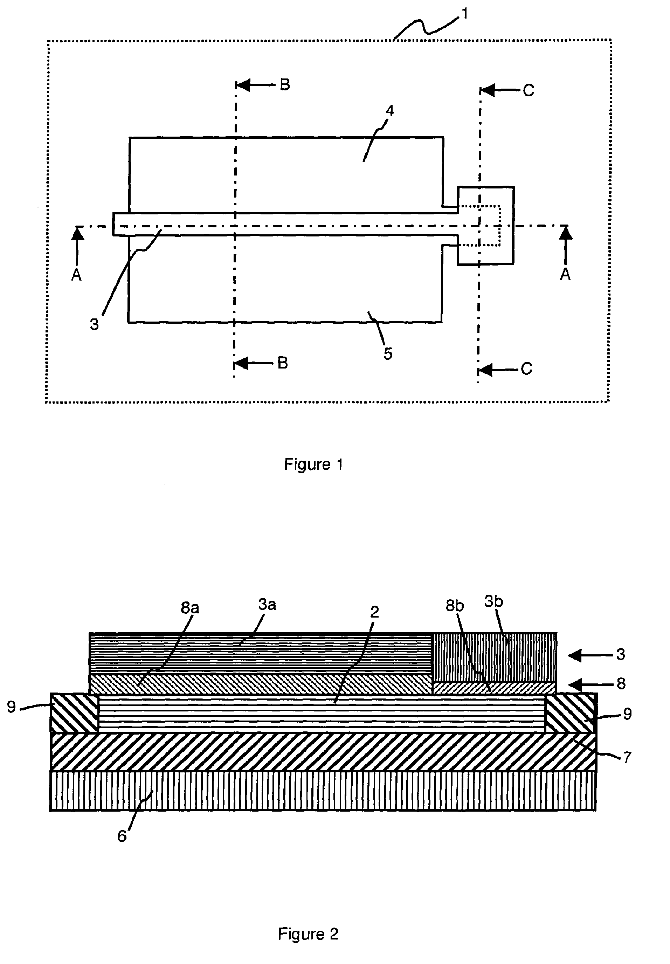

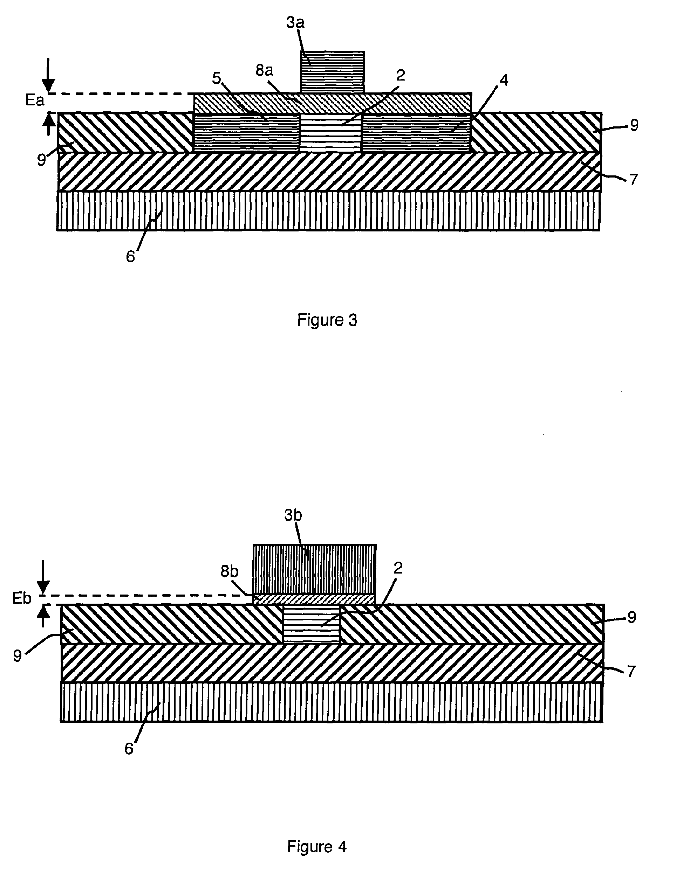

La cellule mémoire DRAM sans capacité est constituée d'un dispositif 1 de type MOSFET partiellement déserté, représenté aux figures 1 à 4, qui comporte un substrat à potentiel flottant, appelé substrat flottant, en matériau semi-conducteur et comprenant dans sa partie supérieure un canal 2 (voir figure 2) disposé sous une grille 3. Des électrodes de source et de drain 4 et 5 sont formées de part et d'autre du canal 2.

Comme représenté à la figure 2, le dispositif comporte successivement un substrat de base 6, un isolant enterré 7, le substrat flottant en matériau semi-conducteur comprenant le canal 2, au moins un isolant de grille 8 et la grille 3. La grille 3 est, par exemple, en poly-silicium. La grille 3 comporte une première zone dopée 3a par un premier type de dopant (par exemple P+) et une seconde zone dopée 3b par un second type de dopant, opposé (par exemple N+). Le canal 2 en matériau semi-conducteur est dopé par le second type de dopant. Ainsi, la seconde zone dopée 3b est dopée par le même type de dopant que le canal 2. Une connexion par effet tunnel est, ainsi, formée entre la seconde zone dopée 3b et le canal 2. Dans l'exemple, le premier type de dopant est P+ et le second type de dopant est N+. Dans un autre exemple, le premier type de dopant peut être N et le second type de dopant est ainsi P.

Les électrodes de source et de drain 4 et 5 sont dopées par le premier type de dopant. Les électrodes de source et de drain 4 et 5 et le canal 2 sont, par exemple, formées dans une couche active délimitée latéralement par des éléments isolants 9.

L'isolant de grille 8 comporte une première partie 8a correspondant à la première zone dopée 3a et une seconde partie 8b correspondant à la seconde zone dopée 3b de la grille 3.

Dans le mode de réalisation particulier représenté aux figures 2 à 4, la première partie 8a de l'isolant de grille 8 a une épaisseur Ea plus élevée que l'épaisseur Eb de la seconde partie 8b de l'isolant de grille 8. Ainsi, même lorsque les matériaux des première (8a) et seconde (8b) parties sont les mêmes, la première partie 8a de l'isolant de grille 8 a une résistance tunnel plus élevée que la seconde partie 8b de l'isolant de grille 8.

Par exemple, la première partie 8a de l'isolant de grille 8 a une épaisseur Ea comprise entre 1,2nm et 7nm, et de préférence entre 2nm et 5nm, et la seconde partie 8b de l'isolant de grille 8 a une épaisseur Eb comprise entre 1 nm et 2,2nm.

Les première et seconde parties 8a et 8b de l'isolant de grille 8 peuvent, par exemple, être formées par le même matériau, par exemple en un matériau compris dans le groupe comprenant l'oxyde de silicium SiO₂, les oxydes carbonés de silicium SiOC, les oxydes hydrocarbonés de silicium SiOCH et les oxydes nitrurés de silicium SiON ou de Hafnium HfON.

La première partie 8a de l'isolant de grille 8 a, ainsi, une résistance tunnel plus élevée que la seconde partie 8b de l'isolant de grille 8. Grâce à l'épaisseur Ea plus élevée de la première zone 8a de l'isolant de grille 8, on peut utiliser des tensions plus élevées, notamment pour les applications analogiques, sans provoquer de courants tunnel à travers la première partie 8a de l'isolant de grille, tandis que la jonction tunnel correspondant à la seconde zone dopée 3b de la grille 3 est ajustée par l'épaisseur Eb de la seconde partie 8b de l'isolant de grille 8 pour favoriser le courant tunnel, indépendamment de la première partie 8a.

L'effet tunnel direct entre la seconde zone dopée 3b de la grille 3 et le canal 2 est favorisé par la réduction de l'épaisseur Eb de la seconde partie 8b de l'isolant de grille 8 ou par le choix d'un diélectrique de plus faible constante diélectrique ou de hauteur de barrière plus faible, pour la seconde partie 8b de l'isolant de grille 8, que le diélectrique de la première partie 8a de l'isolant de grille 8.

Dans les dispositifs de l'art antérieur, si la tension d'alimentation est élevée, il faut augmenter l'épaisseur du diélectrique pour que celui-ci ne soit pas dégradé mais, alors, il n'y a plus de conduction par effet tunnel puisque le diélectrique est trop épais.

La première partie 8a de l'isolant de grille 8 peut avoir une constante diélectrique plus élevée que la seconde partie 8b de l'isolant de grille 8. La première partie 8a de l'isolant de grille 8 peut, par exemple, être en un matériau à forte constante diélectrique (type high K), par exemple en un matériau compris dans le groupe comprenant l'oxyde de hafnium HfO₂, les silicates de hafnium HfSiO_{X} (X étant compris entre 1 et 3) et l'oxyde nitruré de silicium SiON. La seconde partie 8b de l'isolant de grille 8 peut, par exemple être en un matériau compris dans le groupe comprenant l'oxyde de silicium SiO₂, les oxydes carbonés de silicium SiOC et les oxydes hydrocarbonés de silicium SiOCH.

Dans un mode de réalisation préférentiel, la première partie 8a de l'isolant de grille 8 est en SiO₂ et a une épaisseur comprise entre 2nm et 3nm, et la seconde partie 8b de l'isolant de grille 8 est également en SiO₂ et a une épaisseur comprise entre 1 nm et 1,5nm.

Dans un autre mode de réalisation, la première partie 8a de l'isolant de grille 8 est en un matériau à forte constante diélectrique et a une épaisseur comprise entre 2nm et 6nm et de préférence de 2,5nm, et la seconde partie 8b de l'isolant de grille 8 est en SiO₂ et a une épaisseur comprise entre 1 nm et 2,2nm et de préférence de 1,5nm.

En fonction des tensions d'alimentation utilisées, on peut envisager différents choix pour les matériaux et leurs épaisseurs. Pour une tension d'alimentation des circuits de 1 V, la première partie 8a de l'isolant de grille 8 peut, par exemple, être en HfO₂ avec une épaisseur de 3nm, et la seconde partie 8b de l'isolant de grille 8 peut être en SiO₂ avec une épaisseur de 1,9nm.

Pour une tension d'alimentation des circuits de 1,2V, la première partie 8a de l'isolant de grille 8 peut, par exemple, être en SiON avec une épaisseur de 2,7nm, et la seconde partie 8b de l'isolant de grille 8 peut être en SiO₂ avec une épaisseur de 1,9nm.

Pour une tension d'alimentation des circuits de 2,5V, la première partie 8a de l'isolant de grille 8 peut, par exemple, être en SiO₂ avec une épaisseur de 5nm, et la seconde partie 8b de l'isolant de grille 8 peut être en SiO₂ avec une épaisseur de 2,2nm. Le SiO₂ peut contenir une faible quantité d'azote (quelques %) afin d'augmenter la qualité du diélectrique.

Les épaisseurs Ea et Eb et/ou les matériaux de la première (8a) et seconde (8b) partie de l'isolant de grille 8 peuvent, par exemple, être déterminés par l'intermédiaire de simulations ou de calculs théoriques, connus de l'homme de l'art. Des calculs théoriques peuvent, par exemple, être effectués à partir de modèles de conduction par effet tunnel direct ou par effet tunnel de type Fowler-Nordheim. Il est également possible de déterminer les épaisseurs Ea et Eb et/ou les matériaux de la première (8a) et seconde (8b) partie de l'isolant de grille 8 par l'intermédiaire d'essais expérimentaux à base d'assemblages de type condensateur ou transistor, en mesurant des caractéristiques courant-tension ou capacité-tension. A titre d'exemple, une densité de courant de fuite de 800pA/µm² est suffisante sous 1 V de tension, pour réguler le potentiel du canal, à partir d'un courant tunnel à travers un oxyde de silicium nitruré d'une épaisseur de 1,9 nm disposé entre une couche de silicium monocristallin de type N et du polysilicium de type N+. Ce courant tunnel est généré par le passage des électrons accumulés dans le polysilicium de type N+ vers la couche de silicium monocristallin de type N.

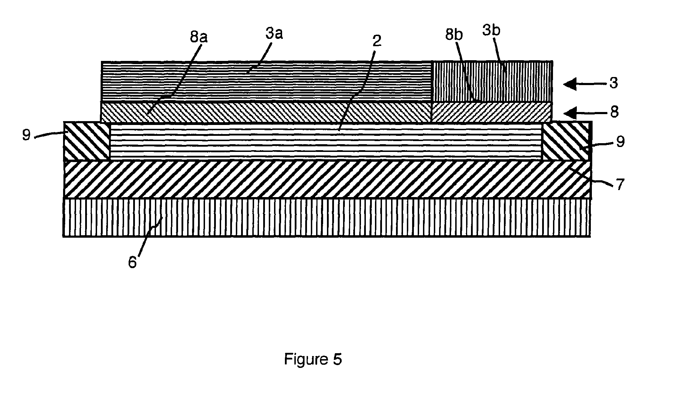

Dans le mode de réalisation particulier représenté à la figure 5, les épaisseurs Ea et Eb sont égales. Dans ce cas, les matériaux des première (8a) et seconde (8b) parties sont différents. Le matériau de la première partie 8a de l'isolant de grille 8 peut, par exemple, présenter une hauteur de barrière plus importante que le matériau de la seconde partie 8b de l'isolant de grille 8. Lorsque les épaisseurs des première et seconde parties sont égales, le matériau de la première partie 8a de l'isolant de grille 8 a, de préférence, une constante diélectrique moins importante que le matériau de la seconde partie 8b de l'isolant de grille 8.

Par exemple, la première partie 8a peut être en oxyde de silicium SiO₂ et la seconde partie 8b peut être en un oxyde à forte constante diélectrique, par exemple en HfO₂, les deux parties 8a et 8b ayant la même épaisseur, par exemple de 2nm. La conduction par effet tunnel direct de la seconde partie 8b est, dans ce cas, supérieure de plusieurs décades à celle de la première partie 8a. La première partie 8a de l'isolant de grille 8 a donc une résistance tunnel plus élevée que la seconde partie 8b de l'isolant de grille 8.

L'élément commun des différents modes de réalisation est le fait que la première partie 8a et la seconde partie 8b de l'isolant de grille 8 sont distinctes. En effet, elles se distinguent notamment par leur épaisseur et/ou par leur matériau. Le dispositif selon l'invention peut être fabriqué par l'intermédiaire des techniques habituellement utilisées en micro-électronique, comme les dépôts de résines, lithographies et implantations ioniques.

Comme précisé plus haut, la cellule mémoire de type DRAM sans capacité (« DRAM capacitorless » ou « 1T DRAM » en anglais) est constituée par le dispositif MOSFET partiellement déserté. Dans cette cellule mémoire le stockage de l'information au sein du dispositif est réalisé classiquement au moyen de l'effet de substrat flottant des transistors MOS de type SOI partiellement désertée.

Classiquement, dans l'art antérieur, ce type de cellule mémoire sans capacité est, de préférence, réalisé au moyen de transistors NMOS. Dans ce type de cellule mémoire, des porteurs de charge (des trous pour un transistor NMOS) sont injectés dans la zone neutre du substrat flottant. Ces porteurs, confinés dans une région bornée par l'oxyde enterré, l'oxyde de grille et les jonctions source et drain, s'accumulent dans le substrat flottant et modifient son potentiel. Ce potentiel augmente dans le cas d'un transistor NMOS, mettant en direct la jonction source/substrat flottant. La tension de seuil du transistor est ainsi réduite et le courant drain augmente. Dans ce cas, le substrat flottant est utilisé comme zone de stockage d'une charge mémoire. Cette charge stockée (état 1 de la mémoire) peut être évacuée en polarisant en direct la jonction drain/substrat. L'état 0 de la mémoire correspond à l'absence de charge dans le substrat flottant.

Contrairement aux cellules mémoires sans capacité de type connu, où la création de charges dans le substrat flottant est réalisée par ionisation par impact (« A SOI capacitor-less 1T-DRAM Concept », S. Okhonin et al. Proc. Of the IEEE International SOI Conf, p. 153, 2001), favorisant ainsi l'utilisation de transistors NMOS, l'utilisation d'une cellule mémoire constituée d'un transistor comportant une zone ayant une résistance tunnel plus faible autorise aisément l'introduction de charges dans le substrat flottant par cette zone. Par contre, pour les cellules mémoires selon l'invention, il est préférable d'utiliser un dispositif de type PMOS.

La phase de lecture est typiquement réalisée en passant le transistor à l'état conducteur ou « On », c'est-à-dire, par exemple, pour un dispositif de type PMOS, en appliquant un potentiel de l'ordre de -0,1 V sur le drain et un potentiel de l'ordre de -0,6V sur la grille, la source étant arbitrairement fixée à 0. La différence de potentiel existant entre la grille et la source est inférieure à la différence de potentiel seuil à partir de laquelle il y a création d'un courant tunnel direct suffisant pour introduire des charges dans le substrat flottant. Cette différence de potentiel seuil est reliée à la résistance tunnel de l'isolant de grille 8 et traduit la différence de potentiel pour laquelle le courant tunnel direct présente un effet important sur les caractéristiques du dispositif. D'une façon générale, le signe des différences de potentiel entre les électrodes du transistor ainsi que leurs amplitudes précises dépendent du type de dispositif (NMOS ou PMOS) et du noeud technologique utilisés.

L'écriture d'un « 1 » s'effectue en réalisant l'introduction, dans le substrat flottant, de charges, ici des électrons, provenant de la seconde zone 3b dopée de la grille 3 à travers la seconde partie de l'isolant de grille 8b. La seconde zone dopée 3b est préférentiellement utilisée car elle présente une résistance tunnel plus faible que la première zone dopée. Cette phase d'écriture d'un « 1 » est réalisée, par exemple, en appliquant un potentiel de l'ordre de -1 V sur la grille, de -0,1 V sur le drain, la source étant fixée arbitrairement à 0, c'est-à-dire en appliquant une tension entre la grille et la source Vgs de -1 V et une tension entre le drain et la source Vds de -0,1 V. De façon schématique, les conditions des potentiels de la lecture sont reprises mais l'amplitude de la différence de potentiel entre la source et la grille est augmentée, par exemple d'environ 50% ou en appliquant une différence de potentiel environ 10 fois plus grande entre la grille et le drain qu'entre la source et le drain ou alors d'une manière quasi-équivalente en appliquant une différence de potentiel environ 10 fois plus grande entre la grille et la source qu'entre la source et le drain. Cette augmentation de la différence de potentiel permet d'obtenir une différence de potentiel entre la grille et la source supérieure à la différence de potentiel seuil et donc la création d'un courant tunnel direct suffisant, depuis la grille 3, pour induire des charges dans le substrat flottant.

Par ailleurs, pour un dispositif PMOS, l'écriture d'un « 0 » est réalisée, par exemple, en fixant au même potentiel la source et la grille, par exemple à 0, et en fixant le drain à 0,1 V. D'une manière générale, l'écriture d'un « 0 » est effectuée en appliquant entre la source et le drain une différence de potentiel de même amplitude mais de signe opposé à celle de la lecture ou l'écriture d'un « 1 ». Ainsi, la jonction drain/substrat flottant est polarisée en direct. Les charges stockées dans le substrat flottant sont ainsi évacuées.

La phase de rétention est effectuée, de façon classique sans appliquer de différence de potentiel entre les différentes électrodes.

## Revendications

1. Cellule mémoire DRAM sans capacité constituée par un dispositif (1) de type MOSFET partiellement déserté comportant successivement un substrat de base (6), un isolant enterré (7), un substrat flottant en matériau semi-conducteur incluant un canal (2), au moins un isolant de grille (8) et une grille (3), la grille (3) comportant une première zone (3a) dopée par un premier type de dopant et au moins une seconde zone (3b) dopée par un second type de dopant, le canal (2) en matériau semi-conducteur étant dopé par le second type de dopant, cellule mémoire **caractérisée en ce que** l'isolant de grille (8) comporte une première partie (8a) correspondant à la première zone dopée (3a) et une seconde partie (8b) correspondant à la seconde zone dopée (3b) de la grille (3), la première partie (8a) de l'isolant de grille (8) ayant une résistance tunnel plus élevée que la seconde partie (8b) de l'isolant de grille (8).

2. Cellule mémoire selon la revendication 1, **caractérisée en ce que** la première partie (8a) de l'isolant de grille (8) et la seconde partie (8b) de l'isolant de grille (8) ont des épaisseurs (Ea et Eb) égales, les matériaux des première (8a) et seconde (8b) parties de l'isolant de grille (8) étant différents, la première partie (8a) de l'isolant de grille (8) a une constante diélectrique moins importante que la seconde partie (8b) de l'isolant de grille (8) .

3. Cellule mémoire selon la revendication 1, **caractérisée en ce que** la première partie (8a) de l'isolant de grille (8) a une épaisseur (Ea) plus élevée que la seconde partie (8b) de l'isolant de grille (8).

4. Cellule mémoire selon la revendication 4, **caractérisée en ce que** les première et seconde parties (8a, 8b) de l'isolant de grille (8) sont formées par le même matériau.

5. Cellule mémoire selon la revendication 4, **caractérisée en ce que** la première partie (8a) de l'isolant de grille (8) a une constante diélectrique plus élevée que la seconde partie (8b) de l'isolant de grille (8).

6. Procédé d'utilisation de la cellule mémoire DRAM selon l'une quelconque des revendications 1 à 5, **caractérisé en ce que** l'injection de porteurs de charge pour écrire un état 1 est réalisée par l'application simultanée d'une différence de potentiel entre la grille (3) et la source (4), supérieure à la différence de potentiel seuil caractéristique du courant tunnel à travers la seconde partie de l'isolant de grille (8b), et d'une différence de potentiel entre la source (4) et le drain (5), typique d'un état conducteur du dispositif.

7. Procédé selon la revendication 6, **caractérisé en ce que** lors de l'écriture d'un état 1, la différence de potentiel (Vgs) entre la grille (3) et la source (4) est de l'ordre de dix fois la différence de potentiel (Vds) entre le drain (5) et la source (4).

8. Procédé selon l'une des revendications 6 et 7, **caractérisé en ce que** l'écriture d'un état 1 est réalisée par l'application simultanée d'une tension drain-source (Vds) de l'ordre de -0,1 V et d'une tension grille-source (Vgs) de l'ordre de -1 V.

9. Procédé selon l'une quelconque des revendications 6 à 8, **caractérisé en ce que** l'écriture d'un état 0 est réalisée par l'application simultanée d'une différence de potentiel entre la grille (3) et la source (4) sensiblement nulle et d'une différence de potentiel entre le drain (5) et la source opposée à celle de l'écriture d'un état 1.

10. Procédé selon la revendication 9, **caractérisé en ce que** lors de la lecture, la différence de potentiel entre la source (4) et le drain (5) est de l'ordre de quelques dizaines de millivolts.
